# EUROPÄISCHE PATENTSCHRIFT

(11) **EP 0 759 231 B1**
(45) Veröffentlichungstag und Bekanntmachung des Hinweises auf die Patenterteilung: **23.12.1998**
(21) Anmeldenummer: 95918622.2
(22) Anmeldetag: 02.05.1995
(51) Int. Cl.: H03H 9/10

(54) **VERKAPSELUNG FÜR ELEKTRONISCHE BAUELEMENTE**
ENCAPSULATION FOR ELECTRONIC COMPONENTS
ENCAPSULATION DE COMPOSANTS ELECTRONIQUES

(30) Priorität: 02.05.1994 DE 4415411; 13.09.1994 DE 4432566
(43) Veröffentlichungstag der Anmeldung: 26.02.1997
(73) Patentinhaber: SIEMENS MATSUSHITA COMPONENTS GmbH & CO. KG, 81617 München (DE)
(72) Erfinder: FÜRBACHER, Bruno, D-85055 Ingolstadt (DE); LUPP, Friedrich, D-80805 München (DE); PAHL, Wolfgang, D-80336 München (DE); TRAUSCH, Günter, D-81477 München (DE)
(74) Vertreter: Epping, Wilhelm, Dr.-Ing.
(86) Internationale Anmeldenummer: EP9501658
(87) Internationale Veröffentlichungsnummer: WO9530276

(56) Entgegenhaltungen:
- EP-A- 0 367 181
- GB-A- 1 512 593
- JEE JOURNAL OF ELECTRONIC ENGINEERING, Bd. 30, Nr. 317, 1.Mai 1993 Seiten 66-68, XP 000365156 TAKAHIRO UETA 'MOBILECOM DEMANDS SURFACE-MOUNTABLE CRYSTAL UNITS'

## Beschreibung

Die vorliegende Erfindung betrifft eine Verkapselung für elektronische Bauelemente, insbesondere für mit akustischen Oberflächenwellen arbeitende Bauelemente -OFW-Bauelemente - nach dem Oberbegriff des Patentanspruchs 1.

Verkapselungen bzw. Gehäuse für elektronische Bauelemente, insbesondere auch für OFW-Bauelemente für Hochfrequenzanwendungen, sind vorzugsweise hermetisch dicht ausgeführt und bestehen beispielsweise aus einer metallischen Kappe und einer metallischen Bodenplatte oder auch einem teilweise metallisierten Träger für das Bauelementesystem. Im Falle von OFW-Bauelementen ist unter Bauelementesystem generell ein piezoelektrisches Substrat mit darauf aufgebrachten beispielsweise Wandler, Resonatoren oder Reflektoren bildenden metallischen Strukturen sowie elektrischen Anschlüssen für diese metallischen Strukturen zu verstehen. Die metallischen Strukturen sind in der Regel nicht passivierbare Aluminiumstrukturen. Nach dem Einbau in Metall- oder Metall/Keramikgehäuse oder -verkapselung können auf den metallischen Strukturen Kurzschlüsse auftreten, die von elektrisch leitenden metallischen Partikeln hervorgerufen werden. Diese Partikel können sich von der Innenseite der Kappe oder von den metallisierten Bereichen des Bauelementesystemträgers lösen. Weiterhin kann auch das Verlöten oder Verschweißen von Kappe und Bodenplatte oder Bauelementesystemträger eine Quelle für derartige leitfähige metallische Partikel sein, weil nicht vollständig zu vermeidende Löt- oder Schweißspritzer zu Kurzschlüssen auf den metallischen Bauelementestrukturen führen können. Schließlich können auch bei der Drahtkontaktierung an den elektrischen Anschlüssen der metallischen Bauelementestrukturen metallische Partikel entstehen.

Das Problem von Kurzschlüssen durch leitfähige metallische Partikel der vorstehend erläuterten Art kann beispielsweise dadurch vermieden werden, daß entweder die Entstehung der Partikel vermieden wird, vorhandene Partikel entfernt werden oder solche Partikel an unschädlichen Stellen zuverlässig fixiert werden.

An Kappen und metallischen Bodenplatten werden die Partikel überwiegend bei der Herstellung der Kappen, etwa durch Abrieb beim Walzen oder im Tiefzieh- und Stanzwerkzeug gebildet. Mittels intensiver Reinigungsverfahren kann versucht werden, die Partikelzahl möglichst niedrig zu halten oder die Innenseite der Kappen vor der Montage z. B. mit einem Polymer zu beschichten, das die Partikel bindet und fixiert. Polymerbeschichtungen sind jedoch insofern nachteilig, als ihr Aufbringen auf definierte Bereiche, z. B. bei eckigen Kappen, fertigungstechnisch schwierig ist, eine vollständige Beschichtung der Innenoberfläche nicht möglich ist, weil Löt- oder Schweißränder und Bereiche der Wärmeeinflußzone beim Löten oder Schweißen frei bleiben müssen und Platzprobleme durch relativ dicke Schichten sowie Ausgasungen aus dem Polymer die Langzeitfunktionstüchtigkeit der Bauelemente beeinträchtigen.

Weiterhin können metallische Überzüge, beispielsweise aus Nickel, galvanisch oder stromlos (chemisch) aufgebracht werden, um Partikel in Kappen oder auf metallischen Bodenplatten zu fixieren. Auch damit ist jedoch keine vollständige Partikelfreiheit zu realisieren.

Bei keramischen Bauelementesystemträgern ist vor allem an relativ scharfen Kanten ein Abbrechen oder Ablösen von Teilchen der Metallisierung nicht vollständig zu vermeiden, selbst wenn der Bauelementesystemträger in dieser Hinsicht etwa durch Verrundung von Kanten oder ein Enden der Metallisierung vor den Kanten optimal ausgelegt wird.

Weiterhin ist auch eine Drahtkontaktierung nach heutigem Standard nicht vollständig abriebfrei zu realisieren.

Eine Passivierung der Bauelementestrukturen auf dem Substrat durch isolierende ausreichend dicke Schichten unmittelbar auf den Strukturen ist bei hochgenauen Bauelementen in der Regel nicht möglich, da selbst durch sehr dünne Schichten die Bauelementeeigenschaften ungünstig beeinflußt werden. Beispielsweise bei OFW-Bauelementen in Form von Bandpaßfiltern kann dies beispielsweise zu einer Verschiebung der Mittenfrequenz oder einer Erhöhung der Bandbreite führen. Eine Kompensation der Eigenschaftsveränderung von Bauelementen durch unter diesen Gesichtspunkten angepaßte Strukturen ist nicht immer möglich, da nach heutigem Standard das Aufbringen von dünnen Schichten mit ausreichender Reproduzierbarkeit der Schichtdicke nur schwer gelingt.

Aus der GB-A 1 512 593 ist eine Abdeckkappe für ein Oberflächenwellenbauelement bekannt, welche auf das Bauelement aufgeklebt wird und über den Bauelementstrukturen einen Hohlraum ausbildet.

Aus IEEE Journal of Electronic Engineering, Bd. 30, Nr. 317, 1. Mai 1993, Seiten 66 bis 68, XP 000365156, Takahiro Ueta: "Mobilecom Demands Surface-Modulated Crystal Units", ist eine keramische Abdeckkappe für Quarzbauelemente bekannt, die die Bauelementstrukturen unter Ausbildung eines Hohlraums umschließt und die mit Hilfe von Harz, einem niedrig schmelzenden Glas oder mit Hilfe von Lot aufgeklebt und abgedichtet ist.

Aus der EP-A-0 367 181 ist eine zweiteilige Abdeckung für ein Oberflächenwellenfilter bekannt, die aus einem Dichtring und einer darauf aufgelöteten Metallplatte besteht.

Da - wie oben ausgeführt - Kurzschlüsse hervorrufende leitfähige metallische Partikel mit wirtschaftlich vertretbarem Aufwand nicht vollständig zu vermeiden sind und eine direkte Passivierung der Bauelementestrukturen in vielen Fällen möglich ist, liegt der vorliegenden Erfindung die Aufgabe zugrunde, bei OFW-Bauelementen, die metallischen Bauelementestrukturen zuverlässig so gegen leitfähige metallische Partikel abzuschirmen, daß die elektrischen - und bei OFW-Bauelementen auch die akustischen - Eigenschaften nicht unzulässig beeinflußt werden. Die Abdeckung soll darüber hinaus einfach zu realisieren sein.

Diese Aufgabe wird durch eine Verkapselung nach Anspruch 1 gelöst.

Weiterbildung der Erfindung sind Gegenstand von Unteransprüchen.

Die Erfindung wird nachfolgend anhand von in den Figuren der Zeichnung dargestellten Ausführungsbeispiele näher erläutert. Es zeigt:
Figur 1 in schematischer Draufsicht einen Teil einer erfindungsgemäßen Verkapselung für ein OFW-Bauelement;
Figur 2 eine schematische Schnittansicht des Bauelementes nach Figur 1; und
Figur 3 in schematischer Draufsicht ein Bauelement nach den Figuren 1 und 2 mit einer speziell für eine elektrische Kontaktierung strukturierten Abdeckschicht.

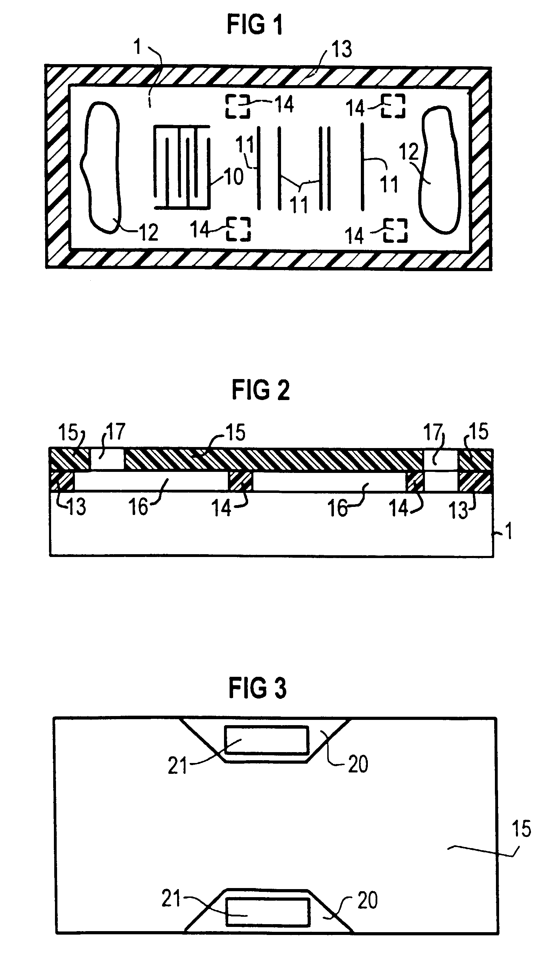

Bei dem in Figur 1 in schematischer Draufsicht dargestellten elektronischen Bauelement handelt es sich um ein OFW-Bauelement mit einem piezoelektrischen Substrat 1, auf dem metallische Bauelementestrukturen 10 und 11 vorgesehen sind, wobei es sich beispielsweise um einen Interdigitalwandler 10 sowie Reflektoren 11 handelt. Derartige Strukturen sind an sich bekannt und werden daher hier nicht näher erläutert. Weiterhin können in bestimmten Bereichen auf dem piezoelektrischen Substrat 1 in an sich bekannter Weise akustische Dämpfungsmassen 12 - sogenannte Besumpfungen - vorgesehen sein. Die vorstehend erläuterte Anordnung wird im eingangs beschriebenen Sinne hier als Bauelementesystem bezeichnet.

Zur Vermeidung der eingangs erläuterten schädlichen Einflüsse von elektrisch leitenden metallischen Partikeln ist erfindungsgemäß auf dem Bauelementesubstrat 1 eine Verkapselung vorgesehen, die gemäß dem Kern der Erfindung durch eine Abdeckung 13, 14, 15 (siehe dazu auch Figur 2) gebildet ist, welche in Bereichen der Bauelementestrukturen 10 bis 12 diese aufnehmende Ausnehmungen 16 (siehe Figur 2) besitzt. Im Ausführungsbeispiel nach Figur 1 ist zwar der Träger 13 so ausgebildet, daß er sich am Außenrand des Substrats 1 befindet. Dies ist jedoch erfindungsgemäß nicht zwingend erforderlich. Beispielsweise kann der Träger 13 auch so ausgebildet sein, daß die Besumpfungen 12 auch ganz oder teilweise außerhalb des Trägers 13 liegen.

In Weiterbildung der Erfindung ist diese Abdeckung (13, 14, 15) durch einen die Bauelementestrukturen 10 bis 12 umgebenden Träger 13 auf dem Bauelementesubstrat 1 und eine auf den Träger aufgebrachte Abdeckschicht 15 gebildet, wobei der Träger 13 vorzugsweise als geschlossener Rahmen ausgebildet ist, so daß in vorteilhafter Weise eine geschlossene hermetisch dichte Verkapselung entsteht. Der Abstand zwischen der Abdeckschicht 15 und den Strukturen 10 und 11 sollte so bemessen sein, daß die bestimmungsgemäße Funktion des Bauelementes im Gebrauch zu keinem Zeitpunkt beeinflußt wird. Der Träger 13 muß jedoch nicht notwendigerweise die Form eines geschlossenen Rahmens besitzen, sondern kann gegebenenfalls auch Durchbrüche enthalten, wodurch Teile der Substratoberfläche zugänglich werden.

Gemäß einer Weiterbildung der Erfindung können zusätzlich zu dem aufrechten rahmenförmigen Träger 13 auch noch Stützen 14 vorgesehen sein, welche zu mechanischen Lagerung der Abdeckschicht 15 beitragen. Die Abdeckung 13, 14, 15 kann gemäß einer Ausführungsform der Erfindung durch eine Folie gebildet werden, die auf der Seite des Bauelementesubstrates 1 die Bauelementestrukturen 11, 12, 13 überspannende Vertiefungen 16 enthält. Dies wird durch partiellen Materialabtrag der für die Abdeckung vorgesehenen Folie realisiert. Die so bearbeitete Folie kann dann beispielsweise durch Kleben, Schweißen oder Laminieren auf das Bauelementesubstrat 1 aufgebracht werden.

Gemäß der Erfindung wird für den Träger 13, die Abdeckschicht 15 und gegebenenfalls die Stützen 14 ein durch Fototechnik strukturierbares Material verwendet. Dies kann beispielsweise ein Fotolack oder ein durch UV-Licht strukturierbares Material sein. Dieses Material wird dann so belichtet, daß nach einem Entwicklungsschritt nur die Bauelementestrukturen 10, 11, 12 und weiterhin auch für die elektrische Kontaktierung dieser Bauelementestrukturen vorgesehene Flächen (siehe Figur 3) freiliegen.

Sodann wird auf den so hergestellten Träger 13 und gegebenenfalls die Stützen 14 eine Abdeckschicht 15 aufgebracht, die ebenfalls aus einem durch Fototechnik strukturierbaren Material der vorstehend genannten Art besteht. Dieses Material kann in Form einer festen Folie aufgebracht werden, die bei ausreichender Dicke der den Träger 13 und gegebenenfalls die Stützen 14 bildenden ersten Lage zusammen mit dieser die Ausnehmungen 16 bilden.

Durch Fotostrukturierung der Abdeckschicht 15 können zur Kontaktierung der Bauelementestrukturen 10 und 11 Bereiche 20 freigelegt werden, wie dies in der Draufsicht nach Figur 3 schematisch dargestellt ist. In diesen Bereichen 20 werden damit für eine Kontaktierung durch Bonden Kontaktierungspads 21 freigelegt.

Nach Fertigstellung der vorstehend erläuterten Abdeckung kann die Weiterverarbeitung des Bauelementes in an sich bekannter Weise erfolgen.

Weiterhin ist es für bestimmte Anwendungen von Vorteil, wenn über der Abdeckung eine Kunststoffumhüllung angeordnet ist, die bevorzugt aus einer Kunststoffolie besteht.

Das Verfahren zum Herstellen einer derartigen Verkapselung besteht darin, daß die Umhüllung des abgedeckten Substrats durch Tauchen, Sintern, Vergießen, Umspritzen oder Umpressen unter Verwendung von Kunststoffmassen auf der Grundlage von Reaktionsharzen oder geschmolzenen Thermoplasten hergestellt wird, wobei bevorzugt Werkstoffe für Abdeckung und Umhüllung verwendet werden, die aufgrund ihrer mechanischen Eigenschaften, vorzugsweise ihres Ausdehnungs- und Schrumpfungsverhaltens nach Fertigstellung der Verkapselung die erforderliche Ausnehmung sicherstellen.

Die Herstellung eines Bauelements nach der Erfindung kann in folgender Weise geschehen.

Im Anschluß an die Waferfertigung erfolgt das Abdecken der Substrate (Chips) mit einer geeigneten Kunststoffolie, die im Bereich der Bauelementestrukturen Ausnehmungen aufweist. Daran schließt sich das Vereinzeln der Chips durch Sägen, Brechen o. dgl. an.
Anschließend erfolgt das Montieren der Chips und die Herstellung der elektrischen Zuführungen in bekannter Weise, indem die Chips auf Trägerstreifen oder Gehäuseteilen befestigt und z.B. mittels Bonddrähten kontaktiert werden. Die Kontaktierung mit Bonddrähten kann auch entfallen, wenn Kontaktfelder auf den Chips zugänglich gehalten werden (z.B. für eine spätere "Chip on Board"-Montage) oder wenn eine berührungslose Signalübertragung (z.B. Induktion) angewandt werden soll.

Nach diesen Verfahrensschritten erfolgt das (vollständige oder teilweise) Umhüllen der Chips durch übliche Verfahren wie Tauchen, Sintern, Vergießen, Umspritzen oder Umpressen mit Werkstoffen auf der Grundlage von Reaktionsharzen oder geschmolzenen Thermoplasten. Durch die Abdeckung, mit einer Kunststoffolie, wird dabei gewährleistet, daß die Flächen des Chips mit den Bauelementestrukturen mit der Umhüllmasse überhaupt nicht und mit der Abdeckung zumindest nicht bleibend in Kontakt kommen.

Wird die Umhüllmasse bei hinreichend kleinen Drücken verarbeitet, so erfährt die Abdeckung keine oder nur eine geringfügige Verformung; hierbei wirkt das eingeschlossene Gaspolster zwischen Chip und Abdeckung unterstützend, da durch die Komprimierung dem Niederdrücken der Abdeckung entgegengewirkt wird.

Bei höheren Verarbeitungsdrücken ist ein Niederdrücken der Abdeckung bis auf die Chipoberfläche nicht mehr auszuschließen. Durch Verwendung geeigneter Werkstoffe für Abdeckung und Umhüllung sowie geeigneter Steuerung der Prozeßbedingungen wird jedoch erreicht, daß nach dem Erhärten der Umhüllmasse ein kleiner definierter Abstand (vorzugsweise im µm-Bereich) zwischen Chipoberfläche und Abdeckung ausgebildet wird. Dies ist insbesondere durch geeignete Variation und Kombination der mechanischen Eigenschaften der verwendeten Werkstoffe (unterschiedliche Längenausdehnungen bzw. -schrumpfungen hervorgerufen beispielsweise durch Temperaturunterschiede und/oder chemische Reaktionen) möglich.

Die einzelnen Verfahrensschritte bei der Herstellung eines OFW-Bauelementes werden im folgenden Ausführungsbeispiel aufgezeigt.
- Metallisierung und Strukturierung des Wafers,
- Laminieren des Wafers mit einer UV-strukturierbaren Resistfolie,
- Belichten und Entwickeln zum Freilegen der späteren Hohlräume und gegebenenfalls Kontaktierflächen usw.,
- Laminieren der Abdecklage aus der gleichen Resistfolie auf die so erzeugte Basislage,
- Belichten und Entwickeln derart, daß der Hohlraum abgedeckt bleibt, aber gegebenenfalls andere Stellen (Bondpads, Sägelinien, Justiermarken) freiliegen
- Umpressen der auf ein "Leadframe" (Träger) geklebten Chips mittels eines üblichen Verfahrens.

Beim letzten Verfahrensschritt wird durch den Druck der heißen Preßmasse (ca. 100bar) die Abdeckfolie zunächst fast ganzflächig auf die Chipoberfläche niedergedrückt. Entscheidend ist es nun, daß nach der Erfindung die Preßmasse beim Abkühlen von der Prozeßtemperatur weit weniger zur Chipoberfläche hin- als die Abdeckfolie von ihr wegschrumpft. In Verbindung mit einer guten Haftung der Preßmasse an der Abdeckfolie bildet sich so der gewünschte Hohlraum von einigen µm Höhe über der Chipoberfläche aus.

Es sei schließlich noch darauf hingewiesen, daß in der Abdeckschicht 15 weiterhin Öffnungen 17 vorgesehen werden können, durch die Besumpfungen 12 der obengenannten und in Figur 1 dargestellten Art direkt eingegossen werden können.

## Patentansprüche

1. Verkapselung für mit akustischen Oberflächenwellen arbeitende Bauelemente - OFW-Bauelemente - mit einer Bauelementestrukturen (10, 11, 12) auf einem Substrat (1) verschließenden Kappe (13, 14, 15),
bei der die Kappe (13, 14, 15) durch eine auf dem Substrat (1) vorgesehene Abdeckung gebildet ist, welche in Bereichen der Bauelementestrukturen (10, 11, 12) diese aufnehmende Ausnehmungen (16) besitzt, wobei die Abdeckung (13 bis 16) durch einen die Bauelementestrukturen (10, 11, 12) umgebenden aufrechten Träger (13) auf dem Substrat (1) und eine auf den Träger aufgebrachte Abdeckschicht (15) gebildet ist und wobei als Material für die Abdeckung (13 bis 16) ein durch Fototechnik strukturierbares Material Verwendung findet und die Abdeckung durch Fototechnik strukturiert ist.

2. Verkapselung nach Anspruch 1,
bei der der Träger (13) als geschlossener Rahmen ausgebildet ist.

3. Verkapselung nach einem der Ansprüche 1 bis 4,
bei der zusätzlich zum Träger (13) in von den Bauelementestrukturen (10, 11, 12) verschiedenen Bereichen auf dem Substrat (1) Stützen (14) vorgesehen sind.

4. Verkapselung nach einem der Ansprüche 1 bis 3,
bei der als Material für den Träger (13) und die Stützen (14) ein durch UV-Licht strukturierbares Material Verwendung findet.

5. Verkapselung nach einem der Ansprüche 1 bis 4,
bei der als Material für den Träger (13) und die Stützen (14) ein Fotolack Verwendung findet.

6. Verkapselung nach einem der Ansprüche 1 bis 5,
bei der als Material für die Abdeckschicht (15) Glas Verwendung findet.

7. Verkapselung nach einem der Ansprüche 1 bis 5,
bei der als Material für die Abdeckschicht (15) Glaskeramik Verwendung findet.

8. Verkapselung nach einem der Ansprüche 1 bis 7,
bei der über der Verkapselung eine Umhüllung aus Kunststoff angeordnet ist.

9. Verkapselung nach Anspruch 8,
bei der die Umhüllung aus Kunststoff auf der Grundlage von Reaktionsharzen oder Thermoplasten besteht.

10. Verkapselung nach einem der Ansprüche 1 bis 9,
bei dem für Abdeckung (15) und Umhüllung Werkstoffe Verwendung finden, deren Ausdehnungs- bzw. Schrumpfungsverhalten nach Fertigstellung der Verkapselung die Ausbildung der Ausnehmung sicherstellen.

11. Verkapselung nach einem der Ansprüche 1 bis 10,
bei der die Abdeckung (13 bis 16) so geformt ist, daß sie auf dem Substrat (1) vorgesehene elektrische Anschlüsse (21) freiläßt.

12. Verkapselung nach einem der Ansprüche 1 bis 11,
bei der die Abdeckung (13 bis 16) Öffnungen (17) zum Einbringen einer akustischen Dämpfungsmasse (12) enthält.

## Claims

1. Encapsulation for components which operate using surface acoustic waves - SAW components - having a cap (13, 14, 15) which seals component structures (10, 11, 12) on a substrate (1), in which the cap (13, 14, 15) is formed by a cover which is provided on the substrate (1) and has, in regions of the component structures (10, 11, 12), cutouts (16) which accommodate said component structures (10, 11, 12), the cover (13 to 16) being formed by an upright carrier (13), which surrounds the component structures (10, 11, 12), on the substrate (1) and by a covering layer (15) which is applied onto the carrier and a material which can be structured using a photographic technique being used as the material for the cover (13 to 16) and the cover being structured using a photographic technique.

2. Encapsulation according to Claim 1 in which the carrier (13) is designed as a closed frame.

3. Encapsulation according to one of Claims 1 or 2, in which, in addition to the carrier (13), supports (14) are provided on the substrate (1), in regions other than the component structures (10, 11, 12).

4. Encapsulation according to one of Claims 1 to 3, in which a material which can be structured by UV light is used as the material for the carrier (13) and the supports (14).

5. Encapsulation according to one of Claims 1 to 4, in which a photoresist is used as the material for the carrier (13) and the supports (14).

6. Encapsulation according to one of Claims 1 to 5, in which a glass is used as the material for the covering layer (15).

7. Encapsulation according to one of Claims 1 to 5, in which glass ceramic is used as the material for the covering layer (15).

8. Encapsulation according to one of Claims 1 to 7, in which a plastic sheath is arranged over the encapsulation.

9. Encapsulation according to Claim 8, in which the sheath is composed of plastic on a base of reactive resins or thermoplastics.

10. Encapsulation according to one of Claims 1 to 9, in which materials are used for covering (15) and sheathing, the expansion and shrinkage behaviours of which ensure the formation of the cutout, after completion of the encapsulation.

11. Encapsulation according to one of Claims 1 to 10, in which the cover (13 to 16) is formed such that it leaves free electrical connections (21) which are provided on the substrate (1).

12. Encapsulation according to one of Claims 1 to 11, in which the cover (13 to 16) contains openings (17) for the introduction of an acoustic damping compound (12).

## Revendications

1. Encapsulation pour des composants travaillant avec des ondes acoustiques de surface - composants OAS - qui comporte un chapeau (13, 14, 15) enfermant des structures (10, 11, 12) de composants sur un substrat (1),
dans lequel le chapeau (13, 14, 15) est formé par un recouvrement qui est prévu sur le substrat (1) et qui a dans des parties des structures (10, 11, 12) de composants des évidements (16) qui les reçoivent, le recouvrement (13, à 16) étant formé par un support (13) érigé sur le substrat (1) et entourant les structures (10, 11, 12) de composants, et par une couche (15) de finition déposée sur le support et un matériau pouvant être structuré par photolitographie étant utilisé comme matériau pour le recouvrement (13 à 16) et le recouvrement étant structuré par photolitographie.

2. Encapsulation suivant la revendication 1, dans laquelle le support (13) est réalisé en cadre fermé.

3. Encapsulation suivant l'une des revendications 1 à 4, dans laquelle, en plus du support (13), il est prévu sur le substrat (1) des soutiens (14) dans des zones différentes des structures (10, 11, 12) de composants.

4. Encapsulation suivant l'une des revendications 1 à 3, caractérisée en ce que l'on utilise comme matériau pour le support (13) et les soutiens (14) un matériau pouvant être structuré par de la lumière UV.

5. Encapsulation suivant l'une des revendications 1 à 4, dans laquelle on utilise comme matériau pour le support (13) et les soutiens (14) un vernis photosensible.

6. Encapsulation suivant l'une des revendications 1 à 5, dans laquelle on utilise du verre comme matériau pour la couche (15) de finition.

7. Encapsulation suivant l'une des revendications 1 à 5, dans laquelle on utilise de la vitrocéramique comme matériau pour la couche (15) de finition.

8. Encapsulation suivant l'une des revendications 1 à 7, dans laquelle un revêtement en matière plastique est disposé au dessus de l'encapsulation.

9. Encapsulation suivant la revendication 8, dans laquelle le revêtement en matière plastique est à base de résines de réaction ou de matières thermoplastiques.

10. Encapsulation suivant l'une des revendications 1 à 9, dans laquelle on utilise pour le recouvrement (15) et le revêtement des matériaux dont les comportements de dilatation et de contraction assurent la formation de l'évidement après la finition de l'encapsulation.

11. Encapsulation suivant l'une des revendications 1 à 10, dans laquelle le recouvrement (13 à 16), est formé de manière à dégager des bornes (21) électriques prévues sur le substrat (1).

12. Encapsulation suivant l'une des revendications 1 à 11, dans laquelle le recouvrement (13 à 16) comporte des ouvertures (17) pour introduire une composition (12) d'atténuation acoustique.
